(19) Europäisches Patentamt
European Patent Office
Office européen des brevets

(11) **EP 3 635 784 B1**

(12) **EUROPÄISCHE PATENTSCHRIFT**

(45) Veröffentlichungstag und Bekanntmachung des Hinweises auf die Patenterteilung:
**25.08.2021   Patentblatt 2021/34**

(21) Anmeldenummer: **18728373.4**

(22) Anmeldetag: **30.05.2018**

(51) Int Cl.:
***H01L 27/144*** *(2006.01)*        ***H01L 27/30*** *(2006.01)*

(86) Internationale Anmeldenummer:
**PCT/EP2018/064276**

(87) Internationale Veröffentlichungsnummer:
**WO 2018/224380 (13.12.2018 Gazette 2018/50)**

(54) **SENSORBAUELEMENT UND VERFAHREN ZUM HERSTELLEN DESSELBEN**

SENSOR COMPONENT AND METHOD FOR PRODUCING SAME

COMPOSANT DE DÉTECTION ET PROCÉDÉ DE FABRICATION DE CE DERNIER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.06.2017   DE 102017209498**

(43) Veröffentlichungstag der Anmeldung:
**15.04.2020   Patentblatt 2020/16**

(73) Patentinhaber: **Fraunhofer-Gesellschaft zur Förderung der angewandten Forschung e.V.
80686 München (DE)**

(72) Erfinder: **KIRCHHOF, Christian
01277 Dresden (DE)**

(74) Vertreter: **Stöckeler, Ferdinand et al
Schoppe, Zimmermann, Stöckeler
Zinkler, Schenk & Partner mbB
Patentanwälte
Radlkoferstrasse 2
81373 München (DE)**

(56) Entgegenhaltungen:
**US-B1- 6 278 055**

**Beschreibung**

Die Erfindung betrifft ein Sensorbauelement zur Detektion eines einfallenden Energiestrahlbündels. Genauer betrifft die Erfindung ein analoges Sensorbauelement, welches - im Gegensatz zu digitalen Sensorbauelementen - eine kontinuierliche Positionsinformation bezüglich des einfallenden Energiestrahlbündels liefert. Bekannte analoge Sensorbauelemente zur Detektion eines einfallenden Lichtstrahlbündels weisen eine positionsempfindliche Fotodiode auf, welche in Siliziumtechnologie gefertigt ist. Dabei sind analoge Sensorbauelemente bekannt, welche es ermöglichen, die Position des einfallenden Energiestrahlbündels eindimensional oder zweidimensional zu ermitteln. Das Dokument US 6 278 055 B1 beschreibt ein Sensorbauelement.

Die Aufgabe der Erfindung bestand darin, ein verbessertes Sensorbauelement zur Detektion eines einfallenden Energiestrahlbündels bereitzustellen. Die Aufgabe wird gelöst durch ein Sensorbauelement zur Detektion eines einfallenden Energiestrahlbündels, wobei das Sensorbauelement in einer z-Richtung eines dreidimensionalen Koordinatensystems gestapelte Schichten aufweist, welche parallel zu einer xy-Ebene des dreidimensionalen Koordinatensystems ausgerichtet sind, wobei die Schichten umfassen:

eine erste Fotodiodenschicht, wobei die erste Fotodiodenschicht eine oder mehrere organische fotoaktive Schichten umfasst, welche zwischen zwei Elektrodenschichten der ersten Fotodiodenschicht angeordnet sind, wobei an den Elektrodenschichten der ersten Fotodiodenschicht wenigstens vier Messkontakte angeordnet sind, an welchen jeweils ein Teilstrom eines von dem einfallenden Energiestrahlbündel abhängigen Fotostroms abgreifbar ist,

so dass aus Messungen der wenigstens vier Teilströme der ersten Fotodiodenschicht eine x-Koordinate und eine y-Koordinate in dem dreidimensionalen Koordinatensystem des einfallenden Energiestrahlbündels in den fotoaktiven Schichten der ersten Fotodiodenschicht ermittelbar sind; und

eine an der ersten Fotodiodenschicht festgelegte zweite Fotodiodenschicht, wobei die zweite Fotodiodenschicht eine oder mehrere organische fotoaktive Schichten umfasst, welche zwischen zwei Elektrodenschichten der zweiten Fotodiodenschicht angeordnet sind, wobei an den Elektrodenschichten der zweiten Fotodiodenschicht wenigstens vier Messkontakte angeordnet sind, an welchen jeweils ein Teilstrom eines von dem einfallenden Energiestrahlbündel abhängigen Fotostroms abgreifbar ist, so dass aus Messungen der wenigstens vier Teilströme der zweiten Fotodiodenschicht eine x-Koordinate und eine y-Koordinate in dem dreidimensionalen Koordinatensystem des einfallenden Energiestrahlbündels in den fotoaktiven Schichten der zweiten Fotodiodenschicht ermittelbar sind;

wobei wenigstens eine der Fotodiodenschichten transparent ist.

Unter einem Energiestrahlbündel wird dabei ein Bündel aus im Wesentlichen parallelen Energiestrahlen verstanden, welches im Vergleich zu einer Sensorfläche des Sensorbauelements einen kleinen Querschnitt aufweist.

Eine oder mehrere der gestapelten Schichten können vollflächig ausgeführt sein. Ebenso können eine oder mehrere der gestapelten Schichten ebenförmig ausgeführt sein.

Die erste Fotodiodenschicht und die zweite Fotodiodenschicht können zur Detektion von elektromagnetischen Energiestrahlen insbesondere im Bereich des Infrarotlichts und/oder des sichtbaren Lichts ausgeführt sein.

Die gewünschte spektrale Empfindlichkeit kann dabei durch eine geeignete Auswahl der einen oder mehreren fotoaktiven Schichten und/oder der zwei Elektrodenschichten der ersten Fotodiodenschicht sowie durch eine geeignete Auswahl der einen oder mehreren fotoaktiven Schichten und/oder der zwei Elektrodenschichten der zweiten Fotodiodenschicht erreicht werden. Bevorzugt weisen die erste Fotodiodenschicht und die zweite Fotodiodenschicht dieselbe spektrale Empfindlichkeit auf, so dass ein einfallendes Energie Strahl Bündel mit definierten spektralen Eigenschaften, welches von der ersten Fotodiodenschicht detektiert werden kann, auch von der zweiten Fotodiodenschicht detektiert werden kann.

Eine Fotodiodenschicht wird dann als transparent bezeichnet, wenn sie einen wesentlichen Teil der Energie des zu detektierenden Energiestrahlbündels, beispielsweise 50 % oder mehr, durch sich hindurchtreten lässt. Grundsätzlich genügt es, wenn eine der beiden Fotodiodenschichten transparent ist. In diesem Fall ist das Sensorbauelement allerdings lediglich in der Lage Energiestrahlbündels in der vorgesehenen Weise zu detektieren, welche auf der Seite der transparenten Fotodiodenschicht einfallen. Sind jedoch beide Fotodiodenschichten transparent, dann können Energiestrahlbündel in der vorgesehenen Weise detektiert werden, unabhängig davon von welcher Seite sie einfallen.

Die Formulierung, dass die erste Fotodiodenschicht an der zweiten Fotodiodenschicht festgelegt ist, bedeutet, dass die erste Fotodiodenschicht und die zweite Fotodiodenschicht so miteinander verbunden sind, dass sie bei bestimmungsgemäßem Gebrauch des Sensorbauelements nicht gegeneinander bewegbar sind.

Die Funktion des erfindungsgemäßen Sensorbauelements ist nun die Folgende: Das zu detektierende Energiestrahlbündel trifft auf eine der beiden Fotodiodenschichten und erzeugt dort durch einen fotoelektrischen Effekt einen Fotostrom. Durch diesen Fotostrom wird dann an jedem der wenigstens vier Messkontakte ein Teilstrom erzeugt, wobei die Messkontakte so an den Elektrodenschichten der jeweiligen Fotodiodenschicht angeordnet sind, dass aus Messungen der wenigstens vier Teilströme eine x-Koordinate und eine y-Koordinate des einfallenden Energiestrahlbündels in den fotoaktiven Schichten der Fotodiodenschicht ermittelbar ist. Die zugehörige z-Koordinate ist dabei konstruktiv vorgegeben und somit bekannt. Auf diese Weise ist nun ein erster Punkt des Energiestrahlbündels eindeutig im dreidimensionalen Raum bestimmt.

Weil nun diejenige Fotodiodenschicht, mittels welcher der erste Punkt des Energiestrahlbündels bestimmt wurde, transparent ist, erreicht ein wesentlicher Teil der Energie des Energiestrahlbündels die weitere Fotodiodenschicht, so dass durch das zu detektierende Energiestrahlbündel in der weiteren Fotodiodenschicht durch einen weiteren fotoelektrischen Effekt ein weiterer Fotostrom ausgelöst wird. Durch diesen weiteren Fotostrom werden dann an den wenigstens vier Messkontakten der weiteren Fotodiodenschicht weitere wenigstens vier Teilströme erzeugt, welche bedingt durch die Anordnung der vier Messkontakte der weiteren Fotodiodenschicht, die Ermittlung einer weiteren x-Koordinate und einer weiteren y-Koordinate des Energiestrahlbündels ermöglichen. Auch hier ist die zugehörige weitere z-Koordinate konstruktiv vorgegeben und bekannt. Damit ist nun ein zweiter Punkt des Energiestrahlbündels eindeutig im dreidimensionalen Raum bestimmt.

Durch den dreidimensional eindeutig bestimmten ersten Punkt und durch den dreidimensional eindeutig bestimmten zweiten Punkt ist man auch die Richtung, aus der das Energiestrahlbündel einfällt, bekannt. Damit erlaubt das erfindungsgemäße Sensorbauelement die dreidimensionale Richtung des Energiestrahlbündels zu ermitteln, während herkömmliche Sensorbauelement lediglich ermöglichen, einen Auftreffpunkt des Energiestrahlbündels eindimensional oder zweidimensional zu bestimmen.

Das erfindungsgemäße Sensorbauelement kann insbesondere in optischen Messgeräten zur Abstandsmessung und/oder zur Winkelmessung eingesetzt werden, wobei die gleichzeitige Messung von Einfallsrichtung und Auftreffpunkt die Genauigkeit der jeweiligen Messungen erhöhen kann.

Die vorgesehene Verwendung organischer Materialien für die fotoaktiven Schichten der Fotodiodenschichten ermöglicht dabei die erforderliche Transparenz der jeweiligen Fotodiodenschicht, welche mit herkömmlichen Fotodiodenschichten in Siliziumtechnologie nicht erreichbar ist. Zudem können durch die vorgesehene Verwendung organischer Materialien für die fotoaktiven Schichten größere fotoaktive Flächen erzeugt werden, als dies mittels der Siliziumtechnologie möglich ist, so dass die Genauigkeit der jeweiligen Messungen weiter erhöht werden kann. Die fotoaktiven Schichten, die Elektrodenschichten und auch die weiteren unten beschriebenen Schichten können in einem Vakuumprozess oder in einem Druckprozess großflächig und wirtschaftlich hergestellt werden.

Das erfindungsgemäße Bauelement kann insbesondere in Messgeräten verwendet werden, welche nach dem Prinzip der Triangulation arbeiten. Das Energiestrahlbündel kann dabei mittels eines Lasers erzeugt sein. Eine andere mögliche Anwendung besteht in der Detektion von mechanischen Schwingungen. Aufgrund des Messprinzips kann dabei eine sehr hohe Empfindlichkeit erreicht werden. Mögliche Verwendungen sind im Bereich der Schwingungsüberwachung von Gebäuden und Zügen oder die Detektion von Schwingungen für Mikrofone, Lautsprecher oder Drucksensoren vorstellbar. Auch hier kann es Energiestrahlbündels mittels eines Lasers erzeugt sein.

Derartige Messgeräte können dann insbesondere in der Luft- und Raumfahrttechnik, sowie in anderen Bereichen des Maschinenbaus, in der Medizintechnik und in vielen weiteren technischen Bereichen eingesetzt werden.

Die erzielbare Genauigkeit des Sensorbauelementes kann durch eine dritte Fotodiodenschicht, weiter erhöht werden, welche jeweils an der ersten Fotodiodenschicht festgelegt ist, wobei die dritte Fotodiodenschicht eine oder mehrere organische fotoaktive Schichten umfasst, welche zwischen zwei Elektrodenschichten der dritten Fotodiodenschicht angeordnet sind, wobei an den Elektrodenschichten der dritten Fotodiodenschicht wenigstens vier Messkontakte angeordnet sind, an welchen jeweils ein Teilstrom eines von dem einfallenden Energiestrahlbündel abhängigen Fotostroms abgreifbar ist, so dass aus Messungen der wenigstens vier Teilströme der dritten Fotodiodenschicht eine x-Koordinate und eine y-Koordinate in dem dreidimensionalen Koordinatensystem des einfallenden Energiestrahlbündels in den fotoaktiven Schichten der dritten Fotodiodenschicht ermittelbar sind, wobei wenigstens zwei benachbarte Fotodiodenschichten der Fotodiodenschichten transparent sind.

Selbstverständlich sind auch weitere äquivalent aufgebaute Fotodiodenschichten möglich.

Gemäß einer bevorzugten Weiterbildung der Erfindung sind die erste Fotodiodenschicht und die zweite Fotodiodenschicht an einer gemeinsamen Substratschicht zum Tragen der ersten Fotodiodenschicht und der zweiten Fotodiodenschicht angeordnet. Auf diese Weise kann die Anzahl der insgesamt notwendigen Schichten minimiert werden, so dass das Sensorbauelement mit einer minimierten Anzahl von Herstellungsschritten hergestellt werden kann. In diesem Fall ist die zweite Fotodiodenschicht unmittelbar durch den Schichtaufbau an der ersten Fotodiodenschicht festgelegt.

Nach einer zweckmäßigen Weiterbildung der Erfindung ist die gemeinsame Substratschicht transparent, wobei die erste Fotodiodenschicht und die zweite Fotodiodenschicht in der z-Richtung gesehen auf gegenüberliegenden Seiten der gemeinsamen Substratschicht angeordnet sind. In diesem Fall übernimmt die gemeinsame Substratschicht zusätzlich die Funktion eines Abstandelementes zwischen der ersten Fotodiodenschicht und der zweiten Fotodiodenschicht, so dass separate Abstandelemente nicht erforderlich sind.

Gemäß einer vorteilhaften Weiterbildung der Erfindung sind die erste Fotodiodenschicht und die zweite Fotodiodenschicht in der z-Richtung gesehen auf einer gemeinsamen Seite der geneinsamen Substratschicht angeordnet ,wobei zwischen der ersten Fotodiodenschicht und der zweiten Fotodiodenschicht wenigstens eine transparente und elektrisch isolierende Zwischenschicht angeordnet ist. Auf diese Weise kann die Herstellung des Schichtaufbaus vereinfacht werden, dass sämtliche Schichten auf ein und derselben Seite des Substrat des nacheinander ausgebildet werden können. Die Zwischenschicht kann zur elektrischen Trennung der beiden Fotodiodenschichten und/oder zur mechanischen Beanstandung der beiden Fotodiodenschichten vorgesehen sein.

Nach einer zweckmäßigen Weiterbildung der Erfindung ist geneinsame Substratschicht transparent. In diesem Fall können auch Energiestrahlbündels detektiert werden, welche aus jener Richtung einfallen, auf der die Substratschicht vorgesehen ist.

Gemäß einer zweckmäßigen Weiterbildung der Erfindung die geneinsame Substratschicht elektrisch isolierend. Falls die gemeinsame Substratschicht zwischen den Fotodiodenschichten angeordnet ist, kann so eine elektrische Trennung der beiden Fotodiodenschichten bewirkt werden. Falls die gemeinsame Substratschicht nicht zwischen den Fotodiodenschicht angeordnet ist, kann so eine Isolierung nach außen erreicht werden.

Nach einer zweckmäßigen Weiterbildung der Erfindung ist die erste Fotodiodenschicht an einer ersten Substratschicht zum Tragen der ersten Fotodiodenschicht angeordnet, wobei die zweite Fotodiodenschicht an einer zweiten Substratschicht zum Tragen der zweiten Fotodiodenschicht angeordnet ist, und wobei wenigstens eine der Substratschichten transparent ist. Auf diese Weise ist es möglich, die erste Fotodiodenschicht und die zweite Fotodiodenschicht derart beanstandet anzuordnen, dass dazwischen ein hohler Zwischenraum entsteht. Auf diese Weise kann, in z-Richtung gesehen, ein großer Abstand zwischen der ersten Fotodiodenschicht und der zweiten Fotodiodenschicht erreicht werden, was der Genauigkeit des Sensorbauelements förderlich ist. Zudem wird in dem hohlen Zwischenraum praktisch keine Energie des Energiestrahlbündels absorbiert, so dass die Genauigkeit des Sensorbauelements weiter verbessert ist. Die transparente Substratschicht der einen Fotodiodenschicht ermöglicht es, dass zumindest ein wesentlicher Teil der Energie des Energiestrahlbündels zur jeweils anderen Fotodiodenschicht gelangt. In diesem Fall kann die zweite Fotodiodenschicht über nicht zum Schichtaufbau zugehörige Mittel an der ersten Fotodiodenschicht festgelegt sein. Beispielsweise können beide Fotodiodenschichten unabhängig voneinander an einem Gehäuse des Sensorbauelements festgelegt sein, so dass die zweite Fotodiodenschicht über das Gehäuse an der ersten Fotodiodenschicht festgelegt ist.

Gemäß einer vorteilhaften Weiterbildung der Erfindung ist wenigstens eine Filterschicht zur Einstellung einer spektralen Empfindlichkeit des Sensorbauelementes vorgesehen. Hierdurch kann das Sensorbauelement hinsichtlich seiner spektralen Empfindlichkeit an sein vorgesehenes Einsatzgebiet angepasst werden. Beispielsweise ist es so möglich, die spektrale Empfindlichkeit in den Bereich des nahen und mittleren Infrarots zu verschieben.

Nach einer vorteilhaften Weiterbildung der Erfindung ist der ersten Fotodiodenschicht wenigstens eine erste Konversionsschicht zur Umwandlung von ionisierender Strahlung in Licht zugeordnet, wobei der zweiten Fotodiodenschicht wenigstens eine zweite Konversionsschicht zur Umwandlung von ionisierender Strahlung in Licht zugeordnet ist. Ionisierende Strahlung ist eine Bezeichnung für jede Teilchen- oder elektromagnetische Strahlung, die in der Lage ist, Elektronen aus Atomen oder Molekülen zu, sodass positiv geladene Ionen oder Molekülreste zurückbleiben. Dazu zählen insbesondere im elektromagnetischen Spektrum: Höhenstrahlung (kosmische Strahlung), Gammastrahlung, Röntgenstrahlung und kurzwelligere Ultraviolettstrahlung sowie im Teilchenspektrum: Protonenstrahlen, Elektronenstrahlen und Neutronenstrahlen. Konversionsschichten sind nun in der Lage derartige ionisierende Strahlen in einen Wellenlängenbereich zu konvertieren, der mit Fotodiodenschichten detektiert werden kann. Auf diese Weise ist es nun mittels des erfindungsgemäßen Sensorbauelements möglich, Energiestrahlbündels detektiert, welche aus ionisierenden Strahlen bestehen.

Gemäß einer zweckmäßigen Weiterbildung der Erfindung weist das Sensorbauelement eine elektronische Schaltung auf, welche zur Ermittlung von Messwerten der wenigstens vier Teilströme der ersten Fotodiodenschicht und zur Ermittlung von Messwerten der wenigstens vier Teilströme der zweiten Fotodiodenschicht ausgebildet ist. Die elektronische Schaltung kann unmittelbar auf dem Substrat oder unabhängig davon in einem gemeinsamen Gehäuse mit der Schichtanordnung angeordnet sein. Auf diese Weise kann der Abstand zwischen dem Ort der Entstehung der Teilströme und dem Ort der Messung Teilströme minimiert werden, was die Genauigkeit der Messergebnisse weiter erhöht.

Gemäß einer vorteilhaften Weiterbildung der Erfindung ist der elektronischen Schaltung eine Datenschnittstelle zur Ausgabe der Messwerte der wenigstens vier Teilströme der ersten Fotodiodenschicht und zur Ausgabe der Messwerte der wenigstens vier Teilströme der zweiten Fotodiodenschicht zugeordnet. Die Datenschnittstelle kann ebenfalls unmittelbar auf dem Substrat oder unabhängig davon in einem gemeinsamen Gehäuse mit der Schichtanordnung angeordnet sein. Insbesondere kann es sich um eine elektrische Standardschnittstelle, zum Beispiel eine I2C Datenbusschnittstelle oder eine SMB Datenbusschnittstelle, handeln. Auf diese Weise kann das erfindungsgemäße Sensorbauelement auf einfache Weise übergeordnete System integriert werden.

Gemäß einer bevorzugten Weiterbildung der Erfindung umfassen die wenigstens vier Messkontakte der ersten Fotodiodenschicht zwei Messkontakte zur Ermittlung der x-Koordinate des einfallenden Energiestrahlbündels in den fotoaktiven Schichten der ersten Fotodiodenschicht, welche in x-Richtung des dreidimensionalen Koordinatensystems gesehen an gegenüberliegenden Randbereichen einer der Elektrodenschichten der ersten Fotodiodenschicht angeordnet sind; wobei die wenigstens vier Messkontakte der ersten Fotodiodenschicht zwei Messkontakte zur Ermittlung der y-Koordinate des einfallenden Energiestrahlbündels in den fotoaktiven Schichten der ersten Fotodiodenschicht umfassen, welche in y-Richtung des dreidimensionalen Koordinatensystems gesehen an gegenüberliegenden Randbereichen einer der Elektrodenschichten der ersten Fotodiodenschicht angeordnet sind; wobei die wenigstens vier Messkontakte der zweiten Fotodiodenschicht zwei Messkontakte zur Ermittlung der x-Koordinate des einfallenden Energiestrahlbündels in den fotoaktiven Schichten der zweiten Fotodiodenschicht umfassen, welche in x-Richtung des dreidimensionalen Koordinatensystems gesehen an gegenüberliegenden Randbereichen einer der Elektrodenschichten der zweiten Fotodiodenschicht angeordnet sind; und wobei die wenigstens vier Messkontakte der zweiten Fotodiodenschicht zwei Messkontakte zur Ermittlung der y-Koordinate des einfallenden Energiestrahlbündels in den fotoaktiven Schichten der zweiten Fotodiodenschicht umfassen, welche in y-Richtung des dreidimensionalen Koordinatensystems gesehen an gegenüberliegenden Randbereichen einer der Elektrodenschichten der zweiten Fotodiodenschicht angeordnet sind.

Die Ermittlung der x-Koordinate des einfallenden Energiestrahlbündels in der ersten Fotodiodenschicht kann somit auf der Differenz zweier Teilströme beruhen, welche sich, in x-Richtung gesehen, an endseitig an den Elektrodenschichten gegenüberliegenden Messkontakten einstellen. Die Ermittlung der der y-Koordinate in der ersten Fotodiodenschicht kann dabei auf der Differenz zweier Teilströme beruhen, welche sich, in y-Richtung gesehen, an endseitig an den Elektrodenschichten gegenüberliegenden Messkontakten einstellen.

Weiterhin kann die Ermittlung der x-Koordinate des einfallenden Energiestrahlbündels in der zweiten Fotodiodenschicht, wie bei der ersten Fotodiodenschicht, auf der Differenz zweier Tellströme beruhen, welche sich, in x-Richtung gesehen, an endseitig an den Elektrodenschichten gegenüberliegenden Messkontakten einstellen. Die Ermittlung der der y-Koordinate in der zweiten Fotodiodenschicht kann, wie bei der ersten Fotodiodenschicht, auf der Differenz zweier Teilströme beruhen, welche sich, in y-Richtung gesehen, an endseitig an den Elektrodenschichten gegenüberliegenden Messkontakten einstellen.

In einem weiteren Aspekt betrifft Erfindung ein Verfahren zum Herstellen eines Sensorbauelements zur Detektion eines einfallenden Energiestrahlbündels, wobei in einer z-Richtung eines dreidimensionalen Koordinatensystems gestapelte Schichten ausgebildet werden, welche parallel zu einer xy-Ebene des dreidimensionalen Koordinatensystems ausgerichtet sind, wobei das Verfahren folgende Schritte umfasst:

Ausbilden einer ersten Fotodiodenschicht, so dass die erste Fotodiodenschicht eine oder mehrere organische fotoaktive Schichten umfasst, welche zwischen zwei Elektrodenschichten der ersten Fotodiodenschicht angeordnet sind, so dass an den Elektrodenschichten der ersten Fotodiodenschicht wenigstens vier Messkontakte angeordnet sind, an welchen jeweils ein Teilstrom eines von dem einfallenden Energiestrahlbündel abhängigen Fotostroms abgreifbar ist, so dass aus Messungen der wenigstens vier Teilströme der ersten Fotodiodenschicht eine x-Koordinate und eine y-Koordinate in dem dreidimensionalen Koordinatensystem des einfallenden Energiestrahlbündels in den fotoaktiven Schichten der ersten Fotodiodenschicht ermittelbar sind; und

Ausbilden einer zweiten Fotodiodenschicht, sodass die zweite Fotodiodenschicht an der ersten Fotodiodenschicht festgelegt ist, sodass die zweite Fotodiodenschicht eine oder mehrere organische fotoaktive Schichten umfasst, welche zwischen zwei Elektrodenschichten der zweiten Fotodiodenschicht angeordnet sind, sodass an den Elektrodenschichten der zweiten Fotodiodenschicht wenigstens vier Messkontakte angeordnet sind, an welchen jeweils ein Teilstrom eines von dem einfallenden Energiestrahlbündel abhängigen Fotostroms abgreifbar ist, so dass aus Messungen der wenigstens vier Teilströme der zweiten Fotodiodenschicht eine x-Koordinate und eine y-Koordinate in dem dreidimensionalen Koordinatensystem des einfallenden Energiestrahlbündels in den fotoaktiven Schichten der zweiten Fotodiodenschicht ermittelbar sind;

wobei wenigstens eine der Fotodiodenschichten transparent ausgebildet wird.

Im Folgenden werden die vorliegende Erfindung und deren Vorteile anhand von Figuren näher beschrieben. Es zeigen:

Fig. 1    ein erstes Ausführungsbeispiel eines erfindungsgemäßen Sensorbauelements in einer schematischen räumlichen Darstellung;

Fig. 2    ein zweites Ausführungsbeispiel eines erfindungsgemäßen Sensorbauelements in einer schematischen Seitenansicht;

Fig. 3 ein drittes Ausführungsbeispiel eines erfindungsgemäßen Sensorbauelements in einer schematischen Seitenansicht; und

Fig. 4 ein viertes Ausführungsbeispiel eines erfindungsgemäßen Sensorbauelements in einer schematischen Seitenansicht.

Gleiche oder gleichartige Elemente oder Elemente mit gleicher oder äquivalenter Funktion sind im Folgenden mit gleichen oder gleichartigen Bezugszeichen versehen.

In der folgenden Beschreibung werden Ausführungsbeispiele mit einer Vielzahl von Merkmalen der vorliegenden Erfindung näher beschrieben, um ein besseres Verständnis der Erfindung zu vermitteln. Es ist jedoch festzuhalten, dass die vorliegende Erfindung auch unter Auslassung einzelner der beschriebenen Merkmale umgesetzt werden kann. Es sei auch darauf hingewiesen, dass die in verschiedenen Ausführungsbeispielen gezeigten Merkmale auch in anderer Weise kombinierbar sind, sofern dies nicht ausdrücklich ausgeschlossen ist oder zu Widersprüchen führen würde.

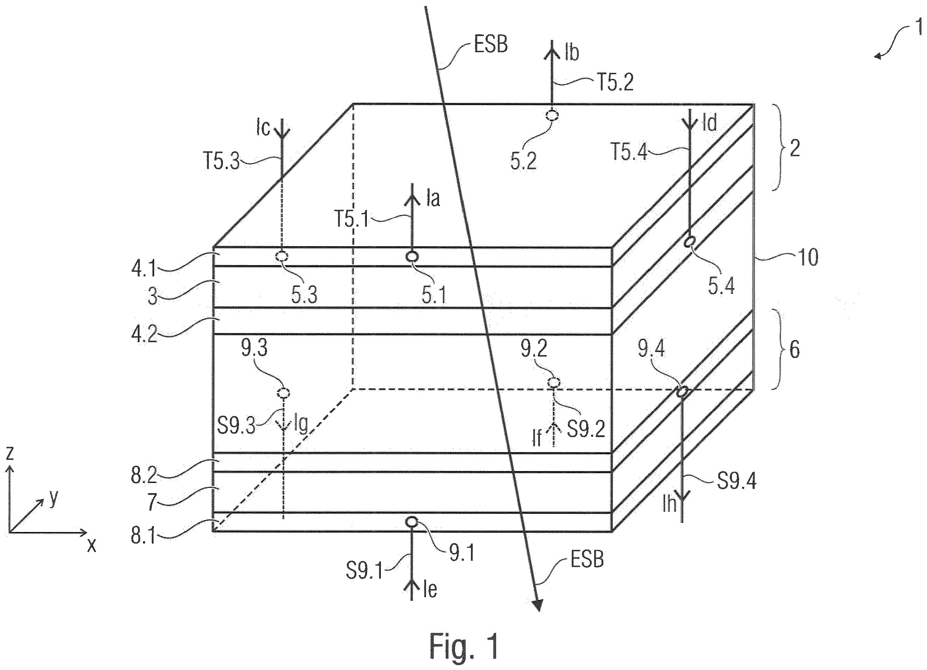

Fig. 1 zeigt ein erstes Ausführungsbeispiel eines erfindungsgemäßen Sensorbauelements in einer schematischen räumlichen Darstellung.

Dargestellt ist ein exemplarisches Sensorbauelement 1 zur Detektion eines einfallenden Energiestrahlbündels ESB, wobei das Sensorbauelement 1 in einer z-Richtung eines dreidimensionalen Koordinatensystems gestapelte Schichten aufweist, welche parallel zu einer xy-Ebene des dreidimensionalen Koordinatensystems ausgerichtet sind, wobei die Schichten umfassen:

eine erste Fotodiodenschicht 2, wobei die erste Fotodiodenschicht 2 eine oder mehrere organische fotoaktive Schichten 3 umfasst, welche zwischen zwei Elektrodenschichten 4.1, 4.2 der ersten Fotodiodenschicht 2 angeordnet sind, wobei an den Elektrodenschichten 4.1, 4.2 der ersten Fotodiodenschicht 2 wenigstens vier Messkontakte 5.1, 5.2, 5.3, 5.4 angeordnet sind, an welchen jeweils ein Teilstrom T5.1, T5.2, T5.3, T5.4 eines von dem einfallenden Energiestrahlbündel ESB abhängigen Fotostroms der ersten Fotodiodenschicht 2 abgreifbar ist, so dass aus Messungen der wenigstens vier Teilströme T5.1, T5.2, T5.3, T5.4 der ersten Fotodiodenschicht 2 eine x-Koordinate und eine y-Koordinate in dem dreidimensionalen Koordinatensystem des einfallenden Energiestrahlbündels EB in den fotoaktiven Schichten 3 der ersten Fotodiodenschicht 2 ermittelbar sind; und

eine an der ersten Fotodiodenschicht 2 festgelegte zweite Fotodiodenschicht 6, wobei die zweite Fotodiodenschicht 6 eine oder mehrere organische fotoaktive Schichten 7 umfasst, welche zwischen zwei Elektrodenschichten 8.1, 8.2 der zweiten Fotodiodenschicht 6 angeordnet sind, wobei an den Elektrodenschichten 8.1, 8.2 der zweiten Fotodiodenschicht 6 wenigstens vier Messkontakte 9.1, 9.2, 9.3, 9.4 angeordnet sind, an welchen jeweils ein Teilstrom S9.1, S9.2, S9.3, S9.4 eines von dem einfallenden Energiestrahlbündel abhängigen Fotostroms der zweiten Fotodiodenschicht 6 abgreifbar ist, so dass aus Messungen der wenigstens vier Teilströme S9.1, S9.2, S9.3, S9.4 der zweiten Fotodiodenschicht 6 eine x-Koordinate und eine y-Koordinate in dem dreidimensionalen Koordinatensystem des einfallenden Energiestrahlbündels ESB in den fotoaktiven Schichten 7 der zweiten Fotodiodenschicht 6 ermittelbar sind;

wobei wenigstens eine der Fotodiodenschichten 2, 6 transparent ist.

Das Sensorbauelement 1 besteht aus (mindestens) zwei organischen Fotodiodenschichten 2, 6, die hintereinander gestapelt sind. Jede dieser Fotodiodenschichten 2, 6 ist mit mindestens vier Teilelektroden 5, 9 versehen und ermöglicht es damit, über die Teilfotoströme TS die x, y-Position des einfallenden Energiestrahlbündels ESB zu berechnen.

Ein einfallendes Energiestrahlbündels ESB durchläuft die erste transparente Fotodiodenschicht 2, in der ein erstes x-y-Koordinatenpaar ermittelt wird. Dabei wird das Energiestrahlbündels ESB nur gering absorbiert. Die zweite Fotodiodenschicht 6, die in einer gestapelten Anordnung dahinter liegt, wird von dem Energiestrahlbündel ESB durchlaufen, wobei wiederum ein x-y-Koordinatenpaar ermittelt wird. Mit der Kenntnis des Abstandes der gestapelten Fotodiodenschichten 2, 6 untereinander, kann mathematisch ein Richtungsvektor des einfallenden Lichtstrahles berechnet werden. Durch eine höhere Anzahl der gestapelten Fotodiodenschichten 2, 6 kann die Genauigkeit erhöht und mögliche Fehler sowie externe Umwelteinflüsse (z.B. Temperatur, Licht) kompensiert werden.

Gemäß einer vorteilhaften Weiterbildung der Erfindung sind die erste Fotodiodenschicht 2 und die zweite Fotodiodenschicht 3 an einer gemeinsamen Substratschicht 10 zum Tragen der ersten Fotodiodenschicht 2 und der zweiten Fotodiodenschicht 6 angeordnet.

Nach einer vorteilhaften Weiterbildung der Erfindung ist die geneinsame Substratschicht 10 transparent, wobei die erste Fotodiodenschicht 2 und die zweite Fotodiodenschicht 6 in der z-Richtung gesehen auf gegenüberliegenden Seiten der geneinsamen Substratschicht 10 angeordnet sind.

Gemäß einer zweckmäßigen Weiterbildung der Erfindung ist die geneinsame Substratschicht 10 elektrisch isolierend.

Nach einer zweckmäßigen Weiterbildung der Erfindung ist geneinsame Substratschicht 10 transparent.

Gemäß einer zweckmäßigen Weiterbildung der Erfindung umfassen die wenigstens vier Messkontakte der ersten Fotodiodenschicht zwei Messkontakte zur Ermittlung der x-Koordinate des einfallenden Energiestrahlbündels in den fotoaktiven Schichten der ersten Fotodiodenschicht, welche in x-Richtung des dreidimensionalen Koordinatensystems gesehen an gegenüberliegenden Randbereichen einer der Elektrodenschichten der ersten Fotodiodenschicht angeordnet sind; wobei die wenigstens vier Messkontakte der ersten Fotodiodenschicht zwei Messkontakte zur Ermittlung der y-Koordinate des einfallenden Energiestrahlbündels in den fotoaktiven Schichten der ersten Fotodiodenschicht umfassen, welche in y-Richtung des dreidimensionalen Koordinatensystems gesehen an gegenüberliegenden Randbereichen einer der Elektrodenschichten der ersten Fotodiodenschicht angeordnet sind; wobei die wenigstens vier Messkontakte der zweiten Fotodiodenschicht zwei Messkontakte zur Ermittlung der x-Koordinate des einfallenden Energiestrahlbündels in den fotoaktiven Schichten der zweiten Fotodiodenschicht umfassen, welche in x-Richtung des dreidimensionalen Koordinatensystems gesehen an gegenüberliegenden Randbereichen einer der Elektrodenschichten der zweiten Fotodiodenschicht angeordnet sind; und wobei die wenigstens vier Messkontakte der zweiten Fotodiodenschicht zwei Messkontakte zur Ermittlung der y-Koordinate des einfallenden Energiestrahlbündels in den fotoaktiven Schichten der zweiten Fotodiodenschicht umfassen, welche in y-Richtung des dreidimensionalen Koordinatensystems gesehen an gegenüberliegenden Randbereichen einer der Elektrodenschichten der zweiten Fotodiodenschicht angeordnet sind.

Wenn die beiden Fotodiodenschichten 2, 6 von dem Energiestrahlbündel ESB punktförmig belichtet werden, dann entsteht jeweils ein Fotostrom, dessen Teilströme T5.1, T5.2, T5.3, T5.4; S9.1, S9.2, S9.3, S9.4 über die an den Rändern liegenden Messkontakte 5.1, 5.2, 5.3, 5.4; 9.1, 9.2, 9.3, 9.4 abfließen und je nach Ort der jeweiligen punktförmigen Belichtung unterschiedliche Werte annehmen. So kann, wenn die z-Achse des Koordinatensystems im Zentrum der Schichtanordnung liegt, die x-Koordinate im Bereich der ersten Fotodiodenschicht 2 nach folgender Formel berechnet werden:

$$x1 = kx1 \ (Id - Ic) \ / \ (Id + Ic).$$

Dabei ist x1 die erste x-Koordinate, kx1 ein Skalierungsfaktor, Ic der Wert des Teilstroms T5.3 und Id der Wert des Teilstroms T5.4.

Dann kann die y-Koordinate im Bereich der ersten Fotodiodenschicht 2 nach folgender Formel berechnet werden:

$$y1 = ky1 \ (Ib - Ia) \ / \ (Ib + Ia).$$

Dabei ist y1 die erste y-Koordinate, ky1 ein Skalierungsfaktor, Ia der Wert des Teilstroms T5.1 und Ib der Wert des Teilstroms T5.2.

Weiterhin kann die x-Koordinate im Bereich der zweiten Fotodiodenschicht 6 nach folgender Formel berechnet werden:

$$x2 = kx2 \ (Ih - Ig) \ / \ (Ih + Ig).$$

Dabei ist x2 die zweite x-Koordinate, kx2 ein Skalierungsfaktor, Ig der Wert des Teilstroms S9.3 und Ich der Wert des Teilstroms S9.4.

Dann kann die y-Koordinate im Bereich der zweiten Fotodiodenschicht 6 nach folgender Formel berechnet werden:

$$y2 = ky2 \ (If - Ie) \ / \ (If + Ie).$$

Dabei ist y2 die zweite y-Koordinate, ky2 ein Skalierungsfaktor, Ie der Wert des Teilstroms S9.1 und If der Wert des Teilstroms S9.2.

Im ersten Ausführungsbeispiel sind die Messkontakte 5.1 und 5.2 als Stromausgang an der ersten Elektrodenschicht 4.1 der ersten Fotodiodenschicht 2 angeordnet. Weiterhin sind die Messkontakte 5.3 und 5.4 als Stromeingang an der zweiten Elektrodenschicht 4.2 der ersten Fotodiodenschicht 2 angeordnet. Es wäre jedoch auch möglich, alle vier Messkontakte 5.1, 5.2, 5.3 und 5.4 als Stromausgang an der ersten Elektrodenschicht 4.1 der ersten Fotodiodenschicht 2 anzuordnen, wobei dann ein weiterer Kontakt als Stromeingang an der zweiten Elektrodenschicht 4.2 der ersten Fotodiodenschicht 2 vorzusehen wäre. Ebenso wäre es möglich, alle vier Messkontakte 5.1, 5.2, 5.3 und 5.4 als Stromeingang an der zweiten Elektrodenschicht 4.2 der ersten Fotodiodenschicht 2 anzuordnen, wobei dann ein weiterer Kontakt als Stromausgang an der ersten Elektrodenschicht 4.1 der ersten Fotodiodenschicht 2 vorzusehen wäre. Bei beiden Varianten behalten die obigen Formen ihre Gültigkeit. Die Ausführungen in diesem Absatz gelten sinngemäß auch für die vier Messkontakte 9.1, 9.2, 9.3 und 9.4 der zweiten Fotodiodenschicht 6.

In einem weiteren Aspekt betrifft Erfindung ein Verfahren zum Herstellen eines Sensorbauelements 1 zur Detektion eines einfallenden Energiestrahlbündels ESB, wobei in einer z-Richtung eines dreidimensionalen Koordinatensystems gestapelte Schichten ausgebildet werden, welche parallel zu einer xy-Ebene des dreidimensionalen Koordinatensystems ausgerichtet sind, wobei das Verfahren folgende Schritte umfasst:

Ausbilden einer ersten Fotodiodenschicht 2, so dass die erste Fotodiodenschicht 2 eine oder mehrere organische fotoaktive Schichten 3 umfasst, welche zwischen zwei Elektrodenschichten 4.1, 4.2 der ersten Fotodiodenschicht 2 angeordnet sind, so dass an den Elektrodenschichten 4.1, 4.2 der ersten Fotodiodenschicht 2 wenigstens vier Messkontakte 5.1, 5.2, 5.3, 5.4 angeordnet sind, an welchen jeweils ein Teilstrom T5.1, T5.2, T5.3, T5.4 eines von dem einfallenden Energiestrahlbündel ESB abhängigen Fotostroms abgreifbar ist, so dass aus Messungen der wenigstens vier Teilströme T5.1, T5.2, T5.3, T5.4 der ersten Fotodiodenschicht 2 eine x-Koordinate und eine y-Koordinate in dem dreidimensionalen Koordinatensystem des einfallenden Energiestrahlbündels ESB in den fotoaktiven Schichten 3 der ersten Fotodiodenschicht ermittelbar sind 2; und

Ausbilden einer zweite Fotodiodenschicht 6, sodass die zweite Fotodiodenschicht 6 an der ersten Fotodiodenschicht 2 festgelegt ist, sodass die zweite Fotodiodenschicht 6 eine oder mehrere organische fotoaktive Schichten 7 umfasst, welche zwischen zwei Elektrodenschichten 8.1, 8.2 der zweiten Fotodiodenschicht 6 angeordnet sind, sodass an den Elektrodenschichten 8.1, 8.2 der zweiten Fotodiodenschicht 6 wenigstens vier Messkontakte 9.1, 9.2, 9.3, 9.4 angeordnet sind, an welchen jeweils ein Teilstrom S9.1, S9.2, S9.3, S9.4 eines von dem einfallenden Energiestrahlbündel ESB abhängigen Fotostroms abgreifbar ist, so dass aus Messungen der wenigstens vier Teilströme S9.1, S9.2, S9.3, S9.4 der zweiten Fotodiodenschicht 6 eine x-Koordinate und eine y-Koordinate in dem dreidimensionalen Koordinatensystem des einfallenden Energiestrahlbündels ESB in den fotoaktiven Schichten 7 der zweiten Fotodiodenschicht 6 ermittelbar sind;

wobei wenigstens eine der Fotodiodenschichten 2, 6 transparent ausgebildet wird.

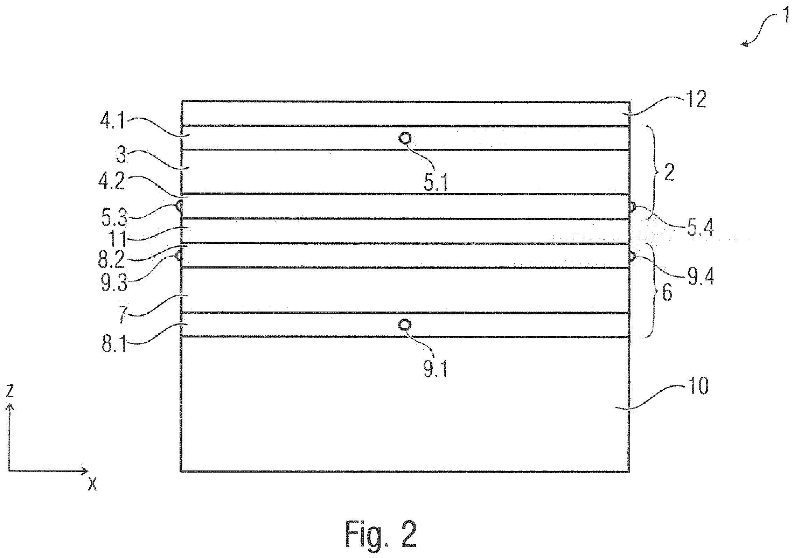

Fig. 2 zeigt ein zweites Ausführungsbeispiel eines erfindungsgemäßen Sensorbauelements 1 in einer schematischen Seitenansicht. Aufgrund der Perspektive sind die Messkontakte 5.2 und 9.2 nicht sichtbar, gleichwohl jedoch vorhanden.

Nach einer zweckmäßigen Weiterbildung der Erfindung sind die erste Fotodiodenschicht 2 und die zweite Fotodiodenschicht 6 in der z-Richtung gesehen auf einer gemeinsamen Seite der gemeinsamen Substratschicht 10 angeordnet, wobei zwischen der ersten Fotodiodenschicht 2 und der zweiten Fotodiodenschicht 6 wenigstens eine transparente und elektrisch isolierende Zwischenschicht 11 angeordnet ist.

Gemäß einer vorteilhaften Weiterbildung der Erfindung ist wenigstens eine Filterschicht 12 zur Einstellung einer spektralen Empfindlichkeit des Sensorbauelementes 1 vorgesehen.

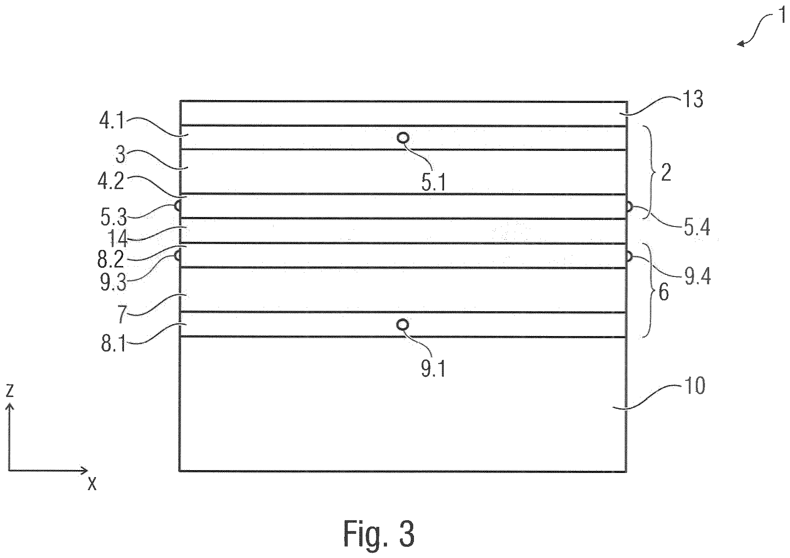

Fig. 3 zeigt ein drittes Ausführungsbeispiel eines erfindungsgemäßen Sensorbauelements 1 in einer schematischen Seitenansicht. Auch hier sind die Messkontakte 5.2 und 9.2 vorhanden, jedoch nicht sichtbar.

Gemäß einer zweckmäßigen Weiterbildung der Erfindung ist der ersten Fotodiodenschicht 2 wenigstens eine erste Konversionsschicht 13 zur Umwandlung von ionisierender Strahlung in Licht zugeordnet, wobei der zweiten Fotodiodenschicht 6 wenigstens eine zweite Konversionsschicht 14 zur Umwandlung von ionisierender Strahlung in Licht zugeordnet ist.

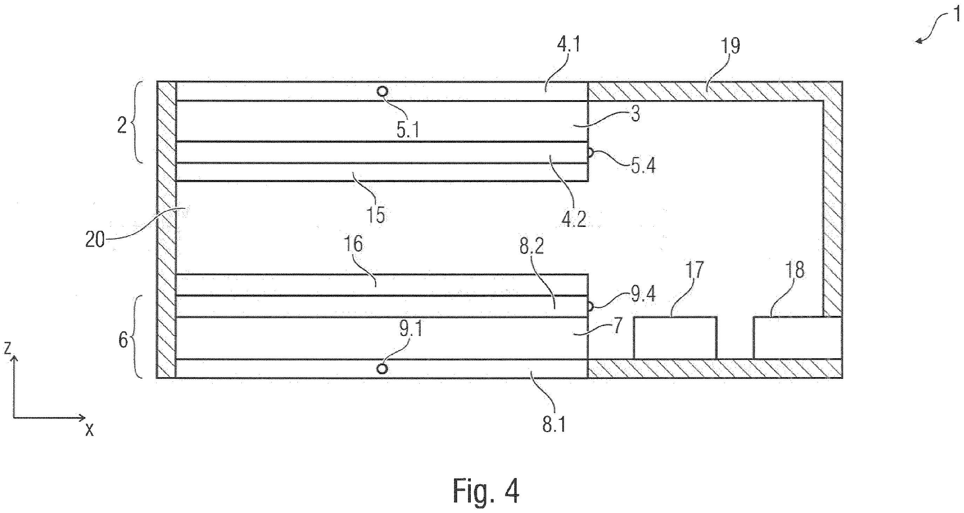

Fig. 4 zeigt ein viertes Ausführungsbeispiel eines erfindungsgemäßen Sensorbauelements 1 in einer schematischen Seitenansicht, wobei auch hier die Messkontakte 5.2 und 9.2 verdeckt sind.

Gemäß einer vorteilhaften Weiterbildung der Erfindung ist die erste Fotodiodenschicht 2 an einer ersten Substratschicht 15 zum Tragen der ersten Fotodiodenschicht 2 angeordnet, wobei die zweite Fotodiodenschicht 6 an einer zweiten Substratschicht 16 zum Tragen der zweiten Fotodiodenschicht 6 angeordnet ist, und wobei wenigstens eine der Substratschichten 15, 16 transparent ist.

Gemäß einer vorteilhaften Weiterbildung der Erfindung weist das Sensorbauelement 1 eine elektronische Schaltung 17 auf, welche zur Ermittlung von Messwerten der wenigstens vier Teilströme T5.1, T5.2, T5.3, T5.4 der ersten Fotodiodenschicht 2 und zur Ermittlung von Messwerten der wenigstens vier Teilströme S9.1, S9.2, S9.3, S9.4 der zweiten Fotodiodenschicht 6 ausgebildet ist.

Nach einer zweckmäßigen Weiterbildung der Erfindung ist der elektronischen Schaltung 17 eine Datenschnittstelle 18 zur Ausgabe der Messwerte der wenigstens vier Teilströme T5.1, T5.2, T5.3, T5.4 der ersten Fotodiodenschicht 2 und zur Ausgabe der Messwerte der wenigstens vier Teilströme T5.1, T5.2, T5.3, T5.4 der zweiten Fotodiodenschicht 6 zugeordnet.

Die erste Fotodiodenschicht 2 und die zweite Fotodiodenschicht 6 sind dabei unabhängig voneinander an einem Gehäuse 19 befestigt, so dass die zweite Fotodiodenschicht 6 über das Gehäuse 19 an der ersten Fotodiodenschicht 2 festgelegt ist. Dabei sind die erste Fotodiodenschicht 2 und die zweite Fotodiodenschicht 6 beabstandet angeordnet so dass ein hohler Zwischenraum 20 entsteht. Die elektronische Schaltung 17 ist ebenfalls unabhängig von den anderen Bestandteilen an dem Gehäuse 19 festgelegt. Die elektronische Schaltung 17 könnte aber auch unmittelbar auf dem gemeinsamen Substrat 10 der Fig. 1 bis 3 oder auf einem der Substrate 15 oder 16 angeordnet sein. Auch die Datenschnittstelle 18 ist an dem Gehäuse 19 angeordnet. Die Datenschnittstelle 18 könnte aber auch unmittelbar auf einem der Substrate 10, 15 oder 16 angeordnet sein. Zudem könnten die elektronische Schaltung 17 und die Datenschnittstelle 18 zu einem einzigen Funktionsteil zusammengefasst sein.

Aspekte der Erfindung, welche im Zusammenhang mit einer Vorrichtung beschrieben sind, betreffen auch korrespondierende Verfahren. Umgekehrt betreffen auch solche Aspekte der Erfindung, welche im Zusammenhang mit einem Verfahren beschrieben sind, auch eine korrespondierende Vorrichtung.

Bezugszeichen:

| | |
|---|---|
| 1 | Sensorbauelement |
| 2 | erste Fotodiodenschicht |
| 3 | fotoaktive Schicht der ersten Fotodiodenschicht |
| 4 | Elektrodenschicht der ersten Fotodiodenschicht |
| 5 | Messkontakt der ersten Fotodiodenschicht |
| 6 | zweite Fotodiodenschicht |
| 7 | fotoaktive Schicht der zweiten Fotodiodenschicht |
| 8 | Elektrodenschicht der zweiten Fotodiodenschicht |
| 9 | Messkontakt der zweiten Fotodiodenschicht |
| 10 | geneinsame Substratschicht |
| 11 | Zwischenschicht |
| 12 | Filterschicht |
| 13 | erste Konversionsschicht |
| 14 | zweite Konversionsschicht |
| 15 | erste Substratschicht |
| 16 | zweite Substratschicht |
| 17 | elektronische Schaltung |
| 18 | Datenschnittstelle |
| 19 | Gehäuse |
| 20 | Zwischenraum |
| ESB | Energiestrahlbündel |
| T | Teilstrom der ersten Fotodiodenschicht |
| S | Teilstrom der zweiten Fotodiodenschicht |

**Patentansprüche**

1. Sensorbauelement zur Detektion eines einfallenden Energiestrahlbündels (ESB), wobei das Sensorbauelement (1) in einer z-Richtung eines dreidimensionalen Koordinatensystems gestapelte Schichten aufweist, welche parallel zu einer xy-Ebene des dreidimensionalen Koordinatensystems ausgerichtet sind, wobei die Schichten umfassen:

   eine erste Fotodiodenschicht (2), wobei die erste Fotodiodenschicht (2) eine oder mehrere organische fotoaktive Schichten (3) umfasst, welche zwischen zwei Elektrodenschichten (4.1, 4.2) der ersten Fotodiodenschicht (2) angeordnet sind, wobei an den Elektrodenschichten (4.1, 4.2) der ersten Fotodiodenschicht (2) wenigstens vier Messkontakte (5.1, 5.2, 5.3, 5.4) angeordnet sind, an welchen jeweils ein Teilstrom (T5.1, T5.2, T5.3, T5.4) eines von dem einfallenden Energiestrahlbündel (ESB) abhängigen Fotostroms der ersten Fotodiodenschicht (2) abgreifbar ist, so dass aus Messungen der wenigstens vier Teilströme (T5.1, T5.2, T5.3, T5.4) der ersten Fotodiodenschicht (2) eine x-Koordinate und eine y-Koordinate in dem dreidimensionalen Koordinatensystem des einfallenden Energiestrahlbündels (EB) in den fotoaktiven Schichten (3) der ersten Fotodiodenschicht (2) ermittelbar sind; und
eine an der ersten Fotodiodenschicht (2) festgelegte zweite Fotodiodenschicht (6), wobei die zweite Fotodiodenschicht (6) eine oder mehrere organische fotoaktive Schichten (7) umfasst, welche zwischen zwei Elektrodenschichten (8.1, 8.2) der zweiten Fotodiodenschicht (6) angeordnet sind, wobei an den Elektrodenschichten (8.1, 8.2) der zweiten Fotodiodenschicht (6) wenigstens vier Messkontakte (9.1, 9.2, 9.3, 9.4) angeordnet sind, an welchen jeweils ein Teilstrom (S9.1, S9.2, S9.3, S9.4) eines von dem einfallenden Energiestrahlbündel abhängigen Fotostroms der zweiten Fotodiodenschicht (6) abgreifbar ist, so dass aus Messungen der wenigstens vier Teilströme (S9.1, S9.2, S9.3, S9.4) der zweiten Fotodiodenschicht (6) eine x-Koordinate und eine y-Koordinate in dem dreidimensionalen Koordinatensystem des einfallenden Energiestrahlbündels (ESB) in den fotoaktiven Schichten (7) der zweiten Fotodiodenschicht (6) ermittelbar sind;
wobei wenigstens eine der Fotodiodenschichten (2, 6) transparent ist.

2. Sensorbauelement nach dem vorstehenden Anspruch , wobei die erste Fotodiodenschicht (2) und die zweite Fotodiodenschicht (3) an einer geneinsamen Substratschicht (10) zum Tragen der ersten Fotodiodenschicht (2) und der zweiten Fotodiodenschicht (6) angeordnet sind.

3. Sensorbauelement nach dem vorstehenden Anspruch, wobei die geneinsame Substratschicht (10) transparent ist und wobei die erste Fotodiodenschicht (2) und die zweite Fotodiodenschicht (6) in der z-Richtung gesehen auf gegenüberliegenden Seiten der geneinsamen Substratschicht (10) angeordnet sind.

4. Sensorbauelement nach Anspruch 2, wobei die erste Fotodiodenschicht (2) und die zweite Fotodiodenschicht (6) in der z-Richtung gesehen auf einer gemeinsamen Seite der geneinsamen Substratschicht (10) angeordnet sind und wobei zwischen der ersten Fotodiodenschicht (2) und der zweiten Fotodiodenschicht (6) wenigstens eine transparente und elektrisch isolierende Zwischenschicht (11) angeordnet ist.

5. Sensorbauelement nach dem vorstehenden Anspruch, wobei die geneinsame Substratschicht (10) transparent ist.

6. Sensorbauelement nach einem der Ansprüche 2 bis 4, wobei die geneinsame Substratschicht (10) elektrisch isolierend ist.

7. Sensorbauelement nach Anspruch 1, wobei die erste Fotodiodenschicht (2) an einer ersten Substratschicht (15) zum Tragen der ersten Fotodiodenschicht (2) angeordnet ist, wobei die zweite Fotodiodenschicht (6) an einer zweiten Substratschicht (16) zum Tragen der zweiten Fotodiodenschicht (6) angeordnet ist, und wobei wenigstens eine der Substratschichten (15, 16) transparent ist.

8. Sensorbauelement nach einem der vorstehenden Ansprüche, wobei wenigstens eine Filterschicht (12) zur Einstellung einer spektralen Empfindlichkeit des Sensorbauelementes (1) vorgesehen ist.

9. Sensorbauelement nach einem der vorstehenden Ansprüche, wobei der ersten Fotodiodenschicht (2) wenigstens eine erste Konversionsschicht (13) zur Umwandlung von ionisierender Strahlung in Licht zugeordnet ist, und wobei der zweiten Fotodiodenschicht (6) wenigstens eine zweite Konversionsschicht (14) zur Umwandlung von ionisierender Strahlung in Licht zugeordnet ist.

10. Sensorbauelement nach einem der vorstehenden Ansprüche, wobei das Sensorbauelement (1) eine elektronische Schaltung (17) aufweist, welche zur Ermittlung von Messwerten der wenigstens vier Teilströme (T5.1, T5.2, T5.3, T5.4) der ersten Fotodiodenschicht (2) und zur Ermittlung von Messwerten der wenigstens vier Teilströme (S9.1, S9.2, S9.3, S9.4) der zweiten Fotodiodenschicht (6) ausgebildet ist.

11. Sensorbauelement nach einem der vorstehenden Ansprüche, wobei der elektronischen Schaltung (17) eine Datenschnittstelle (18) zur Ausgabe der Messwerte der wenigstens vier Teilströme (T5.1, T5.2, T5.3, T5.4) der ersten Fotodiodenschicht (2) und zur Ausgabe der Messwerte der wenigstens vier Teilströme (T5.1, T5.2, T5.3, T5.4) der zweiten Fotodiodenschicht (6) zugeordnet ist.

12. Sensorbauelement nach einem der vorstehenden Ansprüche, wobei die wenigstens vier Messkontakte der ersten Fotodiodenschicht zwei Messkontakte zur Ermittlung der x-Koordinate des einfallenden Energiestrahlbündels in den fotoaktiven Schichten der ersten Fotodiodenschicht umfassen, welche in x-Richtung des dreidimensionalen Koordinatensystems gesehen an gegenüberliegenden Randbereichen einer der Elektrodenschichten der ersten Fotodiodenschicht angeordnet sind; wobei die wenigstens vier Messkontakte der ersten Fotodiodenschicht zwei Messkontakte zur Ermittlung der y-Koordinate des einfallenden Energiestrahlbündels in den fotoaktiven Schichten der ersten Fotodiodenschicht umfassen, welche in y-Richtung des dreidimensionalen Koordinatensystems gesehen an gegenüberliegenden Randbereichen einer der Elektrodenschichten der ersten Fotodiodenschicht angeordnet sind;

wobei die wenigstens vier Messkontakte der zweiten Fotodiodenschicht zwei Messkontakte zur Ermittlung der x-Koordinate des einfallenden Energiestrahlbündels in den fotoaktiven Schichten der zweiten Fotodiodenschicht umfassen, welche in x-Richtung des dreidimensionalen Koordinatensystems gesehen an gegenüberliegenden Randbereichen einer der Elektrodenschichten der zweiten Fotodiodenschicht angeordnet sind; und

wobei die wenigstens vier Messkontakte der zweiten Fotodiodenschicht zwei Messkontakte zur Ermittlung der y-Koordinate des einfallenden Energiestrahlbündels in den fotoaktiven Schichten der zweiten Fotodiodenschicht umfassen, welche in y-Richtung des dreidimensionalen Koordinatensystems gesehen an gegenüberliegenden Randbereichen einer der Elektrodenschichten der zweiten Fotodiodenschicht angeordnet sind.

13. Verfahren zum Herstellen eines Sensorbauelements (1) zur Detektion eines einfallenden Energiestrahlbündels (ESB), wobei in einer z-Richtung eines dreidimensionalen Koordinatensystems gestapelte Schichten ausgebildet werden, welche parallel zu einer xy-Ebene des dreidimensionalen Koordinatensystems ausgerichtet sind, wobei das Verfahren folgende Schritte umfasst:

Ausbilden einer ersten Fotodiodenschicht (2), so dass die erste Fotodiodenschicht (2) eine oder mehrere organische fotoaktive Schichten (3) umfasst, welche zwischen zwei Elektrodenschichten (4.1, 4.2) der ersten Fotodiodenschicht (2) angeordnet sind, so dass an den Elektrodenschichten (4.1, 4.2) der ersten Fotodiodenschicht (2) wenigstens vier Messkontakte (5.1, 5.2, 5.3, 5.4) angeordnet sind, an welchen jeweils ein Teilstrom (T5.1, T5.2, T5.3, T5.4) eines von dem einfallenden Energiestrahlbündel (ESB) abhängigen Fotostroms abgreifbar ist, so dass aus Messungen der wenigstens vier Teilströme (T5.1, T5.2, T5.3, T5.4) der ersten Fotodiodenschicht (2) eine x-Koordinate und eine y-Koordinate in dem dreidimensionalen Koordinatensystem des einfallenden Energiestrahlbündels (ESB) in den fotoaktiven Schichten (3) der ersten Fotodiodenschicht ermittelbar sind (2); und

Ausbilden einer zweite Fotodiodenschicht (6), sodass die zweite Fotodiodenschicht (6) an der ersten Fotodiodenschicht (2) festgelegt ist, sodass die zweite Fotodiodenschicht (6) eine oder mehrere organische fotoaktive Schichten (7)

umfasst, welche zwischen zwei Elektrodenschichten (8.1, 8.2) der zweiten Fotodiodenschicht (6) angeordnet sind, sodass an den Elektrodenschichten (8.1, 8.2) der zweiten Fotodiodenschicht (6) wenigstens vier Messkontakte (9.1, 9.2, 9.3, 9.4) angeordnet sind, an welchen jeweils ein Teilstrom (S9.1, S9.2, S9.3, S9.4) eines von dem einfallenden Energiestrahlbündel (ESB) abhängigen Fotostroms abgreifbar ist, so dass aus Messungen der wenigstens vier Teilströme (S9.1, S9.2, S9.3, S9.4) der zweiten Fotodiodenschicht (6) eine x-Koordinate und eine y-Koordinate in dem dreidimensionalen Koordinatensystem des einfallenden Energiestrahlbündels (ESB) in den fotoaktiven Schichten (7) der zweiten Fotodiodenschicht (6) ermittelbar sind;

wobei wenigstens eine der Fotodiodenschichten (2, 6) transparent ausgebildet wird.

## Claims

1. A sensor device for detecting an incident energy beam (ESB), the sensor device (1) comprising layers stacked in a z-direction of a three-dimensional coordinate system, which are aligned parallel to an xy plane of the three-dimensional coordinate system, the layers comprising:

   a first photodiode layer (2), said first photodiode layer (2) comprising one or more organic photoactive layers (3) interposed between two electrode layers (4.1, 4.2) of the first photodiode layer (2), wherein at least four measuring contacts (5.1, 5.2, 5.3, 5.4) are arranged on the electrode layers (4.1, 4.2) of the first photodiode layer (2), at each of which measuring contacts a partial current (T5.1, T5.2, T5.3, T5.4) of a photocurrent of the first photodiode layer (2) dependent on the incident energy beam (ESB) can be tapped, so that an x coordinate and a y coordinate in the three-dimensional coordinate system of the incident energy beam (ESB) in the photoactive layers (3) of the first photodiode layer (2) can be determined from measurements of the at least four partial currents (T5.1, T5.2, T5.3, T5.4) of the first photodiode layer (2); and
   a second photodiode layer (6) fixed to the first photodiode layer (2), the second photodiode layer (6) comprising one or more organic photoactive layers (7) interposed between two electrode layers (8.1, 8.2) of the second photodiode layer (6), wherein at least four measuring contacts (9.1, 9.2, 9.3, 9.4) are arranged on the electrode layers (8.1, 8.2) of the second photodiode layer (6), at each of which measuring contacts a partial current (S9.1, S9.2, S9.3, S9.4) of a photocurrent of the second photodiode layer (6) dependent on the incident energy beam can be tapped, so that an x coordinate and a y coordinate in the three-dimensional coordinate system of the incident energy beam (ESB) in the photoactive layers (7) of the second photodiode layer (6) can be determined from measurements of the at least four partial currents (S9.1, S9.2, S9.3, S9.4) of the second photodiode layer (6); wherein at least one of the photodiode layers (2, 6) is transparent.

2. The sensor device according to the preceding claim, wherein the first photodiode layer (2) and the second photodiode layer (3) are arranged on a common substrate layer (10) for supporting the first photodiode layer (2) and the second photodiode layer (6).

3. The sensor device according to the preceding claim, wherein the common substrate layer (10) is transparent and wherein the first photodiode layer (2) and the second photodiode layer (6) are arranged on opposite sides of the common substrate layer (10) as viewed in the z-direction.

4. The sensor device according to claim 2, wherein the first photodiode layer (2) and the second photodiode layer (6) are arranged on a common side of the common substrate layer (10) as seen in the z-direction, and wherein at least one transparent and electrically insulating intermediate layer (11) is interposed between the first photodiode layer (2) and the second photodiode layer (6).

5. The sensor device according to the preceding claim, wherein the common substrate layer (10) is transparent.

6. The sensor device according to any of claims 2 to 4, wherein the common substrate layer (10) is electrically insulating.

7. The sensor device according to claim 1, wherein the first photodiode layer (2) is arranged on a first substrate layer (15) for supporting the first photodiode layer (2), wherein the second photodiode layer (6) is arranged on a second substrate layer (16) for supporting the second photodiode layer (6), and wherein at least one of the substrate layers (15, 16) is transparent.

8. The sensor device according to any of the preceding claims, wherein at least one filter layer (12) is provided for adjusting a spectral sensitivity of the sensor device (1).

9. The sensor device according to any of the preceding claims, wherein at least one first conversion layer (13) for converting ionizing radiation into light is associated to the first photodiode layer (2), and at least one second conversion layer (14) for converting ionizing radiation into light is associated to the second photodiode layer (6).

10. The sensor device according to any of the preceding claims, wherein the sensor device (1) comprises an electronic circuit (17) configured for determining measured values of the at least four partial currents (T5.1, T5.2, T5.3, T5.4) of the first photodiode layer (2) and for determining measured values of the at least four partial currents (S9.1, S9.2, S9.3, S9.4) of the second photodiode layer (6).

11. The sensor device according to any of the preceding claims, wherein the electronic circuit (17) is assigned a data interface (18) for outputting the measured values of the at least four partial currents (T5.1, T5.2, T5.3, T5.4) of the first photodiode layer (2) and for outputting the measured values of the at least four partial currents (T5.1, T5.2, T5.3, T5.4) of the second photodiode layer (6).

12. The sensor device according to any of the preceding claims, wherein the at least four measuring contacts of the first photodiode layer comprise two measuring contacts for determining the x-coordinate of the incident energy beam in the photoactive layers of the first photodiode layer, which measuring contacts are arranged at opposite edge regions of one of the electrode layers of the first photodiode layer as viewed in the x-direction of the three-dimensional coordinate system;
wherein the at least four measuring contacts of the first photodiode layer comprise two measuring contacts for determining the y-coordinate of the incident energy beam in the photoactive layers of the first photodiode layer, which measuring contacts are arranged at opposite edge regions of one of the electrode layers of the first photodiode layer as viewed in the y-direction of the three-dimensional coordinate system;
wherein the at least four measuring contacts of the second photodiode layer comprise two measuring contacts for determining the x-coordinate of the incident energy beam in the photoactive layers of the second photodiode layer, which measuring contacts are arranged at opposite edge regions of one of the electrode layers of the second photodiode layer as viewed in the x-direction of the three-dimensional coordinate system; and
wherein the at least four measuring contacts of the second photodiode layer comprise two measuring contacts for determining the y-coordinate of the incident energy beam in the photoactive layers of the second photodiode layer, which measuring contacts are arranged at opposite edge regions of one of the electrode layers of the second photodiode layer as viewed in the y-direction of the three-dimensional coordinate system.

13. A method of manufacturing a sensor device (1) for detecting an incident energy beam (ESB), wherein layers stacked in a z-direction of a three-dimensional coordinate system are formed which are aligned parallel to an xy plane of the three-dimensional coordinate system, the method comprising the steps of:

forming a first photodiode layer (2) such that the first photodiode layer (2) comprises one or more organic photoactive layers (3) which are interposed between two electrode layers (4.1, 4.2) of the first photodiode layer (2), so that at least four measuring contacts (5.1, 5.2, 5.3, 5.4) are arranged on the electrode layers (4.1, 4.2) of the first photodiode layer (2), at each of which measuring contacts a partial current (T5.1, T5.2, T5.3, T5.4) of a photocurrent dependent on the incident energy beam (ESB) can be tapped, so that an x coordinate and a y coordinate in the three-dimensional coordinate system of the incident energy beam (ESB) in said photoactive layers (3) of said first photodiode layer can be determined from measurements of the at least four partial currents (T5.1, T5.2, T5.3, T5.4) of the first photodiode layer (2); and
forming a second photodiode layer (6) such that the second photodiode layer (6) is fixed to the first photodiode layer (2) so that the second photodiode layer (6) comprises one or more organic photoactive layers (7) interposed between two electrode layers (8.1, 8.2) of the second photodiode layer (6) so that at least four measuring contacts (9.1, 9.2, 9.3, 9.4) are arranged on the electrode layers (8.1, 8.2) of the second photodiode layer (6).4), at each of which measuring contacts a partial current (S9.1, S9.2, S9.3, S9.4) of a photocurrent dependent on the incident energy beam (ESB) can be tapped, so that an x coordinate and a y coordinate in the three-dimensional coordinate system of the incident energy beam (ESB) in the photoactive layers (7) of the second photodiode layer (6) can be determined from measurements of the at least four partial currents (S9.1, S9.2, S9.3, S9.4) of the second photodiode layer (6);
wherein at least one of the photodiode layers (2, 6) is implemented to be transparent.

## Revendications

1. Composant capteur destiné à détecter un faisceau de rayonnement d'énergie (ESB) incident, dans lequel le composant capteur (1) présente, dans une direction z d'un système de coordonnées tridimensionnel, des couches empilées qui sont orientées de manière parallèle à un plan xy du système de coordonnées tridimensionnel, dans lequel les couches comportent:

une première couche de photodiodes (2), dans lequel la première couche de photodiodes (2) comporte une ou plusieurs couches photo-actives organiques (3) qui sont disposées entre deux couches d'électrodes (4.1, 4.2) de la première couche de photodiodes (2), où sur les couches d'électrodes (4.1, 4.2) de la première couche de photodiodes (2) sont disposés au moins quatre contacts de mesure (5.1, 5.2, 5.3, 5.4) à chacun desquels peut être prélevé un courant partiel (T5.1, T5.2, T5.3, T5.4) du courant photoélectrique de la première couche de photodiodes (2) dépendant du faisceau de rayonnement d'énergie (ESB) incident, de sorte que puissent être déterminées, à partir des mesures des au moins quatre courants partiels (T5.1, T5.2, T5.3, T5.4) de la première couche de photodiodes (2), une coordonnée x et une coordonnée y dans le système de coordonnées tridimensionnel du faisceau de rayonnement d'énergie (ESB) incident dans les couches photo-actives (3) de la première couche de photodiodes (2); et
une deuxième couche de photodiodes (6) fixée à la première couche de photodiodes (2), où la deuxième couche de photodiodes (6) comporte une ou plusieurs couches photo-actives organiques (7) qui sont disposées entre deux couches d'électrodes (8.1, 8.2) de la deuxième couche de photodiodes (6), où sur les couches d'électrodes (8.1, 8.2) de la deuxième couche de photodiodes (6) sont disposés au moins quatre contacts de mesure (9.1, 9.2, 9.3, 9.4) à chacun desquels peut être prélevé un courant partiel (S9.1, S9.2, S9.3, S9.4) du courant photoélectrique de la deuxième couche de photodiode (6) dépendant du faisceau de rayonnement d'énergie incident, de sorte que puissent être déterminées, à partir des mesures des au moins quatre courants partiels (S9.1, S9.2, S9.3, S9.4) de la deuxième couche de photodiodes (6), une coordonnée x et une coordonnée y dans le système de coordonnées tridimensionnel du faisceau de rayonnement d'énergie (ESB) incident dans les couches photo-actives (7) de la deuxième couche de photodiodes (6);
dans lequel au moins une des couches de photodiodes (2, 6) est transparente.

2. Composant capteur selon la revendication précédente, dans lequel la première couche de photodiodes (2) et la deuxième couche de photodiodes (3) sont disposées sur une couche de substrat commune (10) destinée à porter la première couche de photodiodes (2) et la deuxième couche de photodiodes (6).

3. Composant capteur selon la revendication précédente, dans lequel la couche de substrat commune (10) est transparente et dans lequel la première couche de photodiodes (2) et la deuxième couche de photodiodes (6) sont disposées, vues dans la direction z, sur des faces opposées de la couche de substrat commune (10).

4. Composant capteur selon la revendication 2, dans lequel la première couche de photodiodes (2) et la deuxième couche de photodiodes (6) sont disposées, vues dans la direction z, sur une face commune de la couche de substrat commune (10) et dans lequel est disposée, entre la première couche de photodiodes (2) et la deuxième couche de photodiodes (6), au moins une couche intermédiaire transparente et électriquement isolante (11).

5. Composant capteur selon la revendication précédente, dans lequel la couche de substrat commune (10) est transparente.

6. Composant capteur selon l'une des revendications 2 à 4, dans lequel la couche de substrat commune (10) est électriquement isolante.

7. Composant capteur selon la revendication 1, dans lequel la première couche de photodiodes (2) est disposée sur une première couche de substrat (15) destinée à porter la première couche de photodiode (2), dans lequel la deuxième couche de photodiodes (6) est disposée sur une deuxième couche de substrat (16) destinée à porter la deuxième couche de photodiodes (6), et dans lequel au moins une des couches de substrat (15, 16) est transparente.

8. Composant capteur selon l'une des revendications précédentes, dans lequel est prévue au moins une couche filtrante (12) destinée à régler une sensibilité spectrale du composant capteur (1).

9. Composant capteur selon l'une des revendications précédentes, dans lequel est associée, à la première couche de photodiodes (2), au moins une première couche de conversion (13) destinée à convertir le rayonnement ionisant en lumière, et dans lequel est associée, à la deuxième couche de photodiodes (6), au moins une deuxième couche de conversion (14) destinée à convertir le rayonnement ionisant en lumière.

10. Composant capteur selon l'une des revendications précédentes, dans lequel le composant capteur (1) présente un circuit électronique (17) qui est conçu pour déterminer les valeurs de mesure des au moins quatre courants partiels (T5.1, T5.2, T5.3, T5.4) de la première couche de photodiodes (2) et pour déterminer les valeurs de mesure des au moins quatre courants partiels (S9.1, S9.2, S9.3, S9.4) de la deuxième couche de photodiodes (6).

11. Composant capteur selon l'une des revendications précédentes, dans lequel est associée au circuit électronique (17) une interface de données (18) destinée à sortir les valeurs de mesure des au moins quatre courants partiels (T5.1, T5.2, T5.3, T5.4) de la première couche de photodiodes (2) et à sortir les valeurs de mesure des au moins quatre courants partiels (T5.1, T5.2, T5.3, T5.4) de la deuxième couche de photodiodes (6).

12. Composant capteur selon l'une des revendications précédentes, dans lequel les au moins quatre contacts de mesure de la première couche de photodiodes comportent deux contacts de mesure destinés à déterminer la coordonnée x du faisceau de rayonnement d'énergie incident dans les couches photoactives de la première couche de photodiodes, lesquels, vus dans la direction x du système de coordonnées tridimensionnel, sont disposés dans des zones de bord opposées de l'une des couches d'électrodes de la première couche de photodiodes; dans lequel les au moins quatre contacts de mesure de la première couche de photodiodes comportent deux contacts de mesure destinés à déterminer la coordonnée y du faisceau de rayonnement d'énergie incident dans les couches photo-actives de la première couche de photodiodes, lesquels, vus dans la direction y du système de coordonnées tridimensionnel, sont disposés dans des zones de bord opposées de l'une des couches d'électrodes de la première couche de photodiodes; dans lequel les au moins quatre contacts de mesure de la deuxième couche de photodiodes comportent deux contacts de mesure destinés à déterminer la coordonnée x du faisceau de rayonnement d'énergie incident dans les couches photo-actives de la deuxième couche de photodiodes, lesquels, vus dans la direction x du système de coordonnées tridimensionnel, sont disposés dans des zones de bord opposées de l'une des couches d'électrodes de la deuxième couche de photodiodes; et dans lequel les au moins quatre contacts de mesure de la deuxième couche de photodiodes comportent deux contacts de mesure destinés à déterminer la coordonnée y du faisceau de rayonnement d'énergie incident dans les couches photo-actives de la deuxième couche de photodiodes, lesquels, vus dans la direction y du système de coordonnées tridimensionnel, sont disposés dans des zones de bord opposées de l'une des couches d'électrodes de la deuxième couche de photodiodes.

13. Procédé de fabrication d'un composant capteur (1) destiné à détecter un faisceau de rayonnement d'énergie (ESB) incident, dans lequel sont réalisées des couches empilées dans une direction z d'un système de coordonnées tridimensionnel qui sont orientées de manière parallèle à un plan xy du système de coordonnées tridimensionnel, dans lequel le procédé comporte les étapes suivantes consistant à:

réaliser une première couche de photodiodes (2) de sorte que la première couche de photodiodes (2) comporte une ou plusieurs couches photo-actives organiques (3) qui sont disposées entre deux couches d'électrodes (4.1, 4.2) de la première couche de photodiodes (2), de sorte que sur les couches d'électrodes (4.1, 4.2) de la première couche de photodiodes (2) soient disposés au moins quatre contacts de mesure (5.1, 5.2, 5.3, 5.4) à chacun desquels peut être prélevé un courant partiel (T5.1, T5.2, T5.3, T5.4) d'un courant photoélectrique dépendant du faisceau de rayonnement d'énergie (ESB) incident, de sorte qu'à partir des mesures des au moins quatre courants partiels (T5.1, T5.2, T5.3, T5.4) de la première couche de photodiodes (2) puissent être déterminées une coordonnée x et une coordonnée y dans le système de coordonnées tridimensionnel du faisceau de rayonnement d'énergie (ESB) incident dans les couches photo-actives (3) de la première couche de photodiodes (2); et réaliser une deuxième couche de photodiodes (6) de sorte que la deuxième couche de photodiodes (6) soit fixée à la première couche de photodiodes (2), de sorte que la deuxième couche de photodiodes (6) comporte une ou plusieurs couches photo-actives organiques (7) qui sont disposées entre deux couches d'électrodes (8.1, 8.2) de la deuxième couche de photodiodes (6), de sorte que sur les couches d'électrodes (8.1, 8.2) de la deuxième couche de photodiodes (6) soient disposés au moins quatre contacts de mesure (9.1, 9.2, 9.3, 9.4) à chacun desquels peut être prélevé un courant partiel (S9.1, S9.2, S9.3, S9.4) d'un courant photoélectrique dépendant du faisceau de rayonnement d'énergie (ESB) incident, de sorte que des mesures des au moins quatre courants partiels (S9.1, S9.2, S9.3, S9.4) de la deuxième couche de photodiodes (6) puissent être déterminées une coordonnée x et une coordonnée y dans le système de coordonnées tridimensionnel du faisceau de rayonnement d'énergie (ESB) incident dans les couches photo-actives (7) de la deuxième couche de photodiodes (6); dans lequel au moins une des couches de photodiodes (2, 6) est réalisée transparente.

Fig. 1

EP 3 635 784 B1

Fig. 2

Fig. 3

Fig. 4

EP 3 635 784 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6278055 B1